(19) Europäisches Patentamt
European Patent Office
Office européen des brevets

(11) **EP 3 470 860 A1**

(12) **EUROPEAN PATENT APPLICATION**
published in accordance with Art. 153(4) EPC

(43) Date of publication:
**17.04.2019 Bulletin 2019/16**

(51) Int Cl.:
**G01R 31/36** (2019.01)     **G01R 19/165** (2006.01)

(21) Application number: **17809632.7**

(22) Date of filing: **25.05.2017**

(86) International application number:
**PCT/CN2017/086005**

(87) International publication number:
**WO 2017/211193 (14.12.2017 Gazette 2017/50)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **08.06.2016 CN 201610402877**

(71) Applicant: **BYD Company Limited
Shenzhen, Guangdong 518118 (CN)**

(72) Inventors:
• **BAI, Qinggang
Shenzhen
Guangdong 518118 (CN)**
• **WANG, Xiaoping
Shenzhen
Guangdong 518118 (CN)**

(74) Representative: **Gulde & Partner
Patent- und Rechtsanwaltskanzlei mbB
Wallstraße 58/59
10179 Berlin (DE)**

(54) **VOLTAGE DETECTION AND DETERMINATION CIRCUIT AND POWER BATTERY SYSTEM HAVING SAME**

(57)     The present invention discloses a voltage detection and determination circuit and a power battery system having the same. The circuit includes: a detection processing module, connected to a voltage sampling end and configured to output a first detection voltage based on a voltage sampled by the voltage sampling end; a detection similarity processing module, configured to imitate the detection processing module, to generate a reference voltage corresponding to the first detection voltage; a current source module, configured to provide a bias current to the detection processing module and the detection similarity processing module; and a comparison processing module, configured to perform comparison processing on the first detection voltage and the reference voltage, to output a voltage detection signal. The circuit uses the detection similarity processing module to imitate the detection processing module, to generate reference voltage, does not need a reference voltage, and has a simple circuit structure. Moreover, there is no need to consider an influence caused by an offset voltage of a comparator. A voltage sampled by a sampling end may be accurately detected and determined, so that charging and discharging states of a battery pack are correctly identified.

FIG. 5

## Description

## CROSS REFERENCE OF RELATED APPLICATION

This application claims priority to Chinese Patent Application No. 201610402877.2, entitled "VOLTAGE DETECTION AND DETERMINATION CIRCUIT AND POWER BATTERY SYSTEM HAVING SAME", and filed by BYD Co. Ltd. on June 8, 2016.

## BACKGROUND

### Technical Field

The present invention relates to the field of power supply technologies, and in particular, to a voltage detection and determination circuit and a power battery system having the same.

### Related Art

During application of a battery pack, a battery generally has three states, a charging state, a standing state, and a discharging state. To correctly protect the battery pack in different environments in a timely manner, the charging and discharging states of the battery pack always need to be identified. Especially when the battery pack needs temperature protection, there is a significant difference between a charging protection temperature and a discharging protection temperature. If the charging and discharging states are incorrectly identified, different temperatures may cause damage to the battery pack, and even have explosion hazards. Therefore, accurate identification of the charging and discharging states of the battery pack is crucial.

## SUMMARY

The present invention is intended to resolve at least one technical problem in related technologies to some extent. Therefore, an objective of the present invention is to provide a voltage detection and determination circuit. The circuit does not need a reference voltage, and has a simple circuit structure. Moreover, there is no need to consider an influence caused by an offset voltage of a comparator. A voltage sampled by a sampling end may be accurately detected and determined, so that charging and discharging states of a battery pack are correctly identified.

Another objective of the present invention is to provide a power battery system.

To achieve the foregoing objectives, an embodiment of an aspect of the present invention provides a voltage detection and determination circuit, including: a detection processing module, where the detection processing module is connected to a voltage sampling end, and the detection processing module is configured to output a first detection voltage based on a voltage sampled by the voltage sampling end; a detection similarity processing module, where the detection similarity processing module is used to imitate the detection processing module, to generate a reference voltage corresponding to the first detection voltage; a current source module, where the current source module is connected to the detection processing module and the detection similarity processing module, and the current source module provides a bias current to the detection processing module and the detection similarity processing module; and a comparison processing module, where the comparison processing module is connected to the detection processing module and the detection similarity processing module, and the comparison processing module performs comparison processing on the first detection voltage and the reference voltage, to output a voltage detection signal.

According to the voltage detection and determination circuit in this embodiment of the present invention, the detection processing module outputs the first detection voltage based on the voltage sampled by the voltage sampling end, the detection similarity processing module imitates the detection processing module, to generate the reference voltage corresponding to the first detection voltage, then the current source module provides the bias current to the detection processing module and the detection similarity processing module, and finally the comparison processing module performs comparison processing on the first detection voltage and the reference voltage, to output the voltage detection signal. The circuit does not need a reference voltage, and has a simple circuit structure. Moreover, there is no need to consider an influence caused by an offset voltage of a comparator. A voltage sampled by a sampling end may be accurately detected and determined, so that charging and discharging states of a battery pack may be correctly identified.

To achieve the foregoing objectives, an embodiment of another aspect of the present invention provides a power battery system, including the foregoing voltage detection and determination circuit.

According to the power battery system in this embodiment of the present invention, by using the foregoing voltage detection and determination circuit, the detection similarity processing module is used to imitate the detection processing module, to generate a reference voltage. A reference voltage is not needed, and a circuit structure is simple. Moreover, there is no need to consider an influence caused by an offset voltage of a comparator. A voltage sampled by a sampling end may be accurately detected and determined, so that charging and discharging states of a battery pack are correctly identified.

## BRIEF DESCRIPTION OF THE DRAWINGS

The foregoing and/or additional aspects and advantages of the present invention will become apparent and easily comprehensible in description of embodiments with reference to the accompanying figures.

FIG. 1 is a schematic diagram of a current direction of a discharging state of a battery pack in the prior art;

FIG. 2 is a schematic diagram of a current direction of a charging state of a battery pack in the prior art;

FIG. 3 is a schematic diagram of a low voltage detection circuit in the prior art;

FIG. 4 is a schematic diagram of another low voltage detection circuit in the prior art;

FIG. 5 is a schematic block diagram of a voltage detection and determination circuit according to an embodiment of the present invention;

FIG. 6 is a schematic block diagram of a voltage detection and determination circuit according to another embodiment of the present invention; and

FIG. 7 is a circuit conceptual diagram of a voltage detection and determination circuit according to another embodiment of the present invention.

## DETAILED DESCRIPTION

The following describes the embodiments of the present invention in detail, examples of the embodiments are shown in the figures, and same or similar reference signs throughout represent same or similar elements or elements having same or similar functions. The following embodiments described with figures are exemplary, and are intended to explain the present invention, but cannot be constructed as limitation to the present invention.

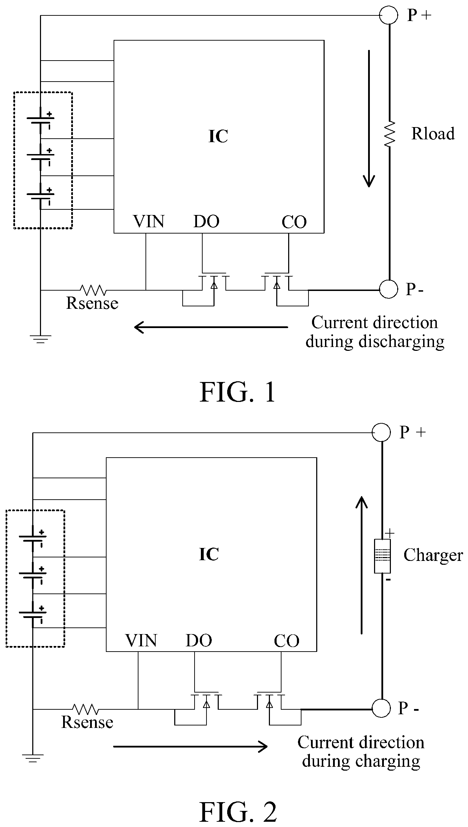

Generally, charging and discharging states of a battery pack need to be identified based on a current direction. A common practice is to convert a current flowing through a current detection resistor Rsense into a voltage for detection. Whether a voltage $V_{VIN}$ of a VIN terminal of an integrated circuit (IC) is positive or negative may be determined based on a current direction. As shown in FIG. 1, when the battery pack is in the discharging state, a current flows from P+ to P- and flows through the current detection resistor Rsense, and the voltage $V_{VIN}$ of the VIN terminal of the IC with reference to GND is a positive voltage, that is, $V_{VIN} = I \times Rsense$. As shown in FIG. 2, when the battery pack is in the charging state, a current flows from P- to P+ and flows through the current detection resistor Rsense, and the voltage $V_{VIN}$ of the VIN terminal of the IC with reference to GND is a negative voltage, that is, $V_{VIN} = -I \times Rsense$. However, because the current detection resistor Rsense is very small, a detected current I is also very small, and a detected voltage $V_{VIN}$ of the VIN terminal is also very small and is on the order of millivolts. Therefore, it is very difficult to detect and determine such a small voltage.

In the related art, detection and determination of a low voltage is implemented by mainly using the following two methods.

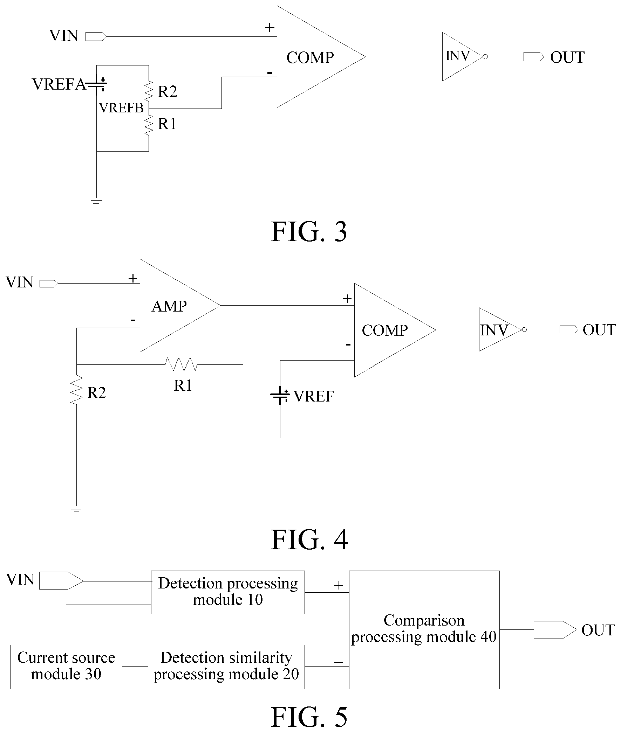

As shown in FIG. 3, the detected voltage $V_{VIN}$ of the VIN terminal is directly compared and determined. That is, one end of a comparator COMP is connected to the VIN terminal, and another end is connected to a reference voltage. Because the voltage VIN is very small, the reference voltage is usually a very small voltage VREFB that is obtained after a relatively large reference voltage VREFA is divided by using resistors. Advantages of this implementation method are: A principle is simple, and the method is easily conceived of. However, the method has many disadvantages: First, to obtain a relatively large reference voltage VREFA, a circuit needs to be added for implementation. Second, VREFB obtained through division by the resistors is affected by the voltage VREFA and ratio precision of voltage divider resistors R1 and R2. Third, a determination result of VIN is affected by an offset voltage VOS of the comparator COMP. Fourth, voltages for direct comparison are relatively small, and therefore, an input common mode level is very small, affecting a gain and an inversion speed of comparison. Fifth, considering from low power consumption for protection of the IC, resistances of the voltage divider resistors R1 and R2 are relatively large, and a relatively wafer area is occupied. This is adverse to cost control. In addition, for the method, even though influences of a reference deviation and a ratio deviation of the voltage divider resistors are not considered, maladjustment of the comparator also cannot be ignored. It may be learned from features of the comparator that a comparator inversion point $Vs = V_{VIN} + VOS$ or $Vs = V_{VIN} - VOS$, and a smaller voltage $V_{VIN}$ for detection and determination (on an order of millivolts) results in a stronger influence of a deviation of the offset voltage VOS (generally on an order of millivolts) caused by a process deviation on the inversion point of the comparator, that is, results in a larger deviation of a current detection and determination value.

As shown in FIG. 4, an improvement is made based on the direct comparison shown in FIG. 3, and the voltage $V_{VIN}$ of the VIN terminal is proportionally amplified by using an operational amplifier AMP and then is compared with the reference voltage. Advantages of this method are: After the voltage is proportionally amplified, voltages that are of two ends of the comparator COMP and that are for comparison are increased, a problem of an insufficient gain caused by a relatively low input common mode level of the comparator COMP is resolved, and voltage division does not need to be performed on the generated reference voltage, so that direct comparison may be performed, thereby reducing a resistance used by voltage division of the reference voltage and reducing a part of the wafer area. However, disadvantages of this method are: First, a relatively large reference voltage VREF still needs to be generated, and a circuit needs to be added for implementation. Second, a deviation of the detection voltage VIN caused by the offset voltage VOS of the comparator still cannot be eliminated, and the deviation is significantly affected by a process fluctuation.

For the foregoing problems, the present invention provides a voltage detection and determination circuit. On one hand, the circuit does not need to generate a reference voltage, thereby reducing used circuits. On the other hand, an influence caused by an offset voltage VOS of the comparator does not need to be considered.

The voltage detection and determination circuit and a power battery system having the same that are provided in the embodiments of the present invention are described below with reference to the accompanying drawings.

FIG. 5 is a schematic block diagram of a voltage detection and determination circuit according to an embodiment of the present invention. As shown in FIG. 5, the voltage detection and determination circuit includes a detection processing module 10, a detection similarity processing module 20, a current source module 30, and a comparison processing module 40.

The detection processing module 10 is connected to a voltage sampling end VIN, and the detection processing module 10 is configured to output a first detection voltage VN based on a voltage $V_{VIN1}$ sampled by the voltage sampling end VIN. The detection similarity processing module 20 is configured to imitate the detection processing module 10, to generate a reference voltage VP corresponding to the first detection voltage VN. The current source module 30 is connected to the detection processing module 10 and the detection similarity processing module 20, and the current source module 30 provides a bias current to the detection processing module 10 and the detection similarity processing module 20. The comparison processing module 40 is connected to the detection processing module 10 and the detection similarity processing module 20, and the comparison processing module 40 performs comparison processing on the first detection voltage VN and the reference voltage VP, to output a voltage detection signal. In this embodiment of the present invention, the detection processing module 10 performs level shift processing on the voltage $V_{VIN1}$ sampled by the voltage sampling end VIN, to output the first detection voltage VN.

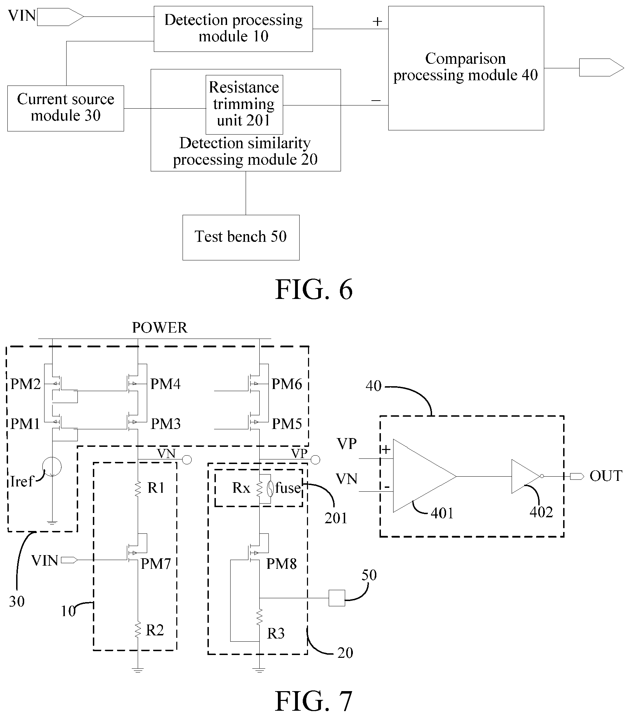

Further, according to an embodiment of the present invention, as shown in FIG. 6, in the foregoing voltage detection and determination circuit, the detection similarity processing module 20 may include a resistance trimming unit 201.

The resistance trimming unit 201 is connected between the current source module 30 and the comparison processing module 40. The resistance trimming unit 201 performs resistance trimming based on resistance and current parameters of the detection similarity processing module 20 and the voltage $V_{VIN1}$ sampled by the voltage sampling end VIN for the first time. The resistance trimming unit 201 obtains the voltage $V_{VIN1}$ sampled by the voltage sampling end VIN for the first time by using the comparison processing module 40.

Specifically, as shown in FIG. 6, the voltage sampling end VIN is connected to the detection processing module 10. Level shift processing is performed on the voltage $V_{VIN1}$ sampled by the voltage sampling end VIN, to obtain a voltage VN having a fixed relationship with $V_{VIN1}$. The detection processing module 10 is connected to one end of the comparison processing module 40. The detection processing module 10 is imitated, to copy the detection similarity processing module 20 having a same structure as that of the detection processing module 10. The detection similarity processing module 20 generates the reference voltage VP, and is connected to another end of the comparison processing module 40. Meanwhile, the detection similarity processing module 20 is connected to a test bench 50. The test bench 50 is configured to detect the resistance and current parameters of the detection similarity processing module 20.

Before resistance trimming is performed, a detected voltage of the voltage sampling end VIN is $V_{VIN1}$, then an actual resistance of the detection similarity processing module 20 tested by the test bench 50 is $R_X$, a theoretical value of a resistance of the detection similarity processing module 20 is R0, and a branch current of the detection similarity processing module 20 is $I_T$. It is assumed that a voltage of the voltage sampling end VIN needing to be obtained is $V_{VIN0}$, that is, a target voltage of the voltage sampling end VIN is $V_{VIN0}$, an actual value of a resistance needing to be trimmed by the resistance trimming unit 201 is $R_{X0} = (V_{VIN0} - V_{VIN1}) / I_T$, and the theoretical value of the resistance needing to be trimmed by the resistance trimming unit 201 is $R_{X0} \times R0 / R_X = (V_{VIN0} - V_{VIN1}) \times R0 / (I_T \times R_X)$. After the resistance trimming unit 201 performs resistance trimming based on the theoretical value, a redetected voltage of the voltage sampling end VIN basically achieves the target voltage $V_{VIN0}$. Finally, the comparison processing module 40 outputs the voltage detection signal after performing comparison processing on the first detection voltage VN and the reference voltage VP, to detect and determine the voltage sampled by the voltage sampling end, and outputs the voltage detection signal from an OUT port. Therefore, the circuit does not need a reference voltage, and has a simple circuit structure. Moreover, there is no need to consider an influence caused by an offset voltage of a comparator. A voltage sampled by a sampling end may be accurately detected and determined, so that charging and discharging states of a battery pack are correctly identified.

According to an embodiment of the present invention, as shown in FIG. 7, the current source module 30 includes an internal constant current source Iref and a current mirror unit.

The current mirror unit includes a first PMOS transistor PM1, a second PMOS transistor PM2, a third PMOS transistor PM3, a fourth PMOS transistor PM4, a fifth PMOS transistor PM5, and a sixth PMOS transistor PM6. Both a source and a gate of the first PMOS transistor PM1 are connected to a positive terminal of the internal constant current source Iref, and a negative terminal of the internal constant current source Iref is grounded. Both a source and a gate of the second PMOS transistor PM2 are connected to a drain of the first PMOS transistor PM1, and a drain of the second PMOS transistor PM2 is connected to an internal power supply POWER. A drain of the third PMOS transistor PM3 is connected to the detection processing module, and a gate of the third PMOS transistor PM3 is connected to the gate of the first PMOS transistor PM1. A drain of the fourth PMOS transistor PM4 is connected to a source of the third PMOS transistor PM3, a gate of the fourth PMOS transistor PM4 is connected to the gate of the second PMOS transistor PM2, and a source of the fourth PMOS transistor PM4 is connected to the internal power supply POWER. A drain of the fifth PMOS transistor PM5 is connected to the detection similarity processing module 20, and a gate of the fifth PMOS transistor PM5 is connected to the gate of the first PMOS transistor PM1. A drain of the sixth PMOS transistor PM6 is connected to a source of the fifth PMOS transistor PM5, a gate of the sixth PMOS transistor PM6 is connected to the gate of the second PMOS transistor PM2, and a source of the sixth PMOS transistor PM6 is connected to the internal power supply POWER.

As shown in FIG. 7, the detection processing module 10 includes a first resistor R1, a seventh PMOS transistor PM7, and a second resistor R2. One end of the first resistor R1 is connected to the current source module 30 and the comparison processing module 40. A source of the seventh PMOS transistor PM7 is connected to the other end of the first resistor R1, and a gate of the seventh PMOS transistor PM7 is connected to the voltage sampling end VIN. One end of the second resistor R2 is connected to a drain of the seventh PMOS transistor PM7, and the other end of the second resistor R2 is grounded.

As shown in FIG. 7, the detection similarity processing module 20 includes an eighth PMOS transistor PM8 and a third resistor R3. A source of the eighth PMOS transistor PM8 is connected to the resistance trimming unit 201, and a gate of the eighth PMOS transistor PM8 is grounded. One end of the third resistor R3 is connected to a drain of the eighth PMOS transistor PM8, and the other end of the third resistor R3 is grounded.

As shown in FIG. 7, the resistance trimming unit 201 includes a trimming resistor $R_X$ and a fuse fuse. One end of the trimming resistor $R_X$ is connected to the current source module 30 and the comparison processing module 40, and the other end of the trimming resistor $R_X$ is connected to the source of the eighth PMOS transistor PM8. The fuse fuse and the trimming resistor $R_X$ are connected in parallel.

As shown in FIG. 7, the comparison processing module 40 includes a comparator 401 and a phase inverter 402. A positive input terminal of the comparator 401 is connected to the detection similarity processing module 20, and a negative input terminal of the comparator 401 is connected to the detection processing module 10. An input terminal of the phase inverter 402 is connected to an output terminal of the comparator 401, and an output terminal of the phase inverter 401 is configured to output the voltage detection signal.

Specifically, branch currents of the detection processing module 10 and the detection similarity processing module 20 are theoretically equivalent, and are both equivalent to a current of the internal constant current source Iref. However, considering that an actual process has a deviation, it is assumed that the branch current of the detection processing module 10 is $I_{VIN}$, a total resistance of the first resistor R1 and the second resistor R2 is $R_{VIN}$, and a threshold VTH7 for turning on the seventh PMOS transistor PM7 is a fixed attribute parameter value, an output voltage of the detection processing module 10 is $VN = V_{VIN1} + I_{VIN} \times R_{VIN} + VTH7$. Meanwhile, a threshold VTH8 for turning on the eighth PMOS transistor PM8 is assumed to be a fixed attribute parameter value. First, a small voltage is added to the test bench 50, and then an actual resistance value of the third resistor R3 is R30 after calculation is performed based on an actual current. Then, the test bench 50 is grounded, and it may be detected that the branch current of the detection similarity processing module 20 is $I_T$. Finally, it may be calculated that the reference voltage $VP = VTH8 + I_T \times R30$.

Specifically, before the resistance trimming unit 201 performs resistance trimming, an inversion point of the comparator 401 is $V_{VIN1}$, and $VN = V_{VIN1} + I_{VIN} \times R_{VIN} + VTH7 = VP + VOS = VTH8 + I_T \times R30 + VOS$, where VOS is an offset voltage of the comparator 401 and is a fixed attribute parameter of the comparator 401. Further, $VOS = V_{VIN1} + I_{VIN} \times R_{VIN} + VTH7 - VTH8 - I_T \times R30$ may be obtained.

After the resistance trimming unit 201 performs resistance trimming, it is assumed that a target voltage of the voltage sampling end VIN is $V_{VIN0}$, and an actual resistance needing to be trimmed by the trimming resistor $R_X$ is $R_{X0}$, $VN = V_{VIN0} + I_{VIN} \times R_{VIN} + VTH7$ and $VP = VTH8 + I_T \times R30 + I_T \times R_{X0}$. The followings may be obtained from $VN = VP + VOS$:

$$V_{VIN0} + I_{VIN} \times R_{VIN} + VTH7$$

$$= VTH8 + I_T \times R30 + I_T \times R_{X0} + VOS$$

$$= VTH8 + I_T \times R30 + I_T \times R_{X0} + V_{VIN1} + I_{VIN} \times R_{VIN} + VTH7 - VTH8 - I_T \times R30$$

$$= I_T \times R_{X0} + V_{VIN1} + I_{VIN} \times R_{VIN} + VTH7$$

$$V_{VIN0} = I_T \times R_{X0} + V_{VIN1}$$

may be obtained by means of simplification.

The actual value $R_{X0}$ needing the trimming resistor is $(V_{VIN0} - V_{VIN1}) / I_T$.

It should be noted that during circuit design, the trimming resistor $R_X$ and the third resistor R3 are placed in a same region, and it may be approximately considered that deviation ratios of the two resistors are consistent. The actual value of the third resistor R3 is R30, and a theoretical value is R31; the actual value of the trimming resistor $R_X$ is $R_{X0}$, and a theoretical value is $R_{X1}$, and $R_{X0} / R_{X1} = R30 / R31$. Therefore, the theoretical value $R_{X1}$ needing the trimming resistor is $R_{X0} \times R31 / R30 = (V_{VIN0} - V_{VIN1}) \times R31 / I_T \times R30$.

Accordingly, it may be learned that provided that the trimming resistor $R_X$ is trimmed based on the theoretical value $R_{X1}$, the sampling voltage $V_{VIN1}$ of the voltage sampling end VIN is basically equivalent to the target voltage $V_{VIN0}$. After the comparator 401 performs comparison processing based on VP and VN, the phase inverter 402 outputs a determination result from the OUT port.

Accordingly, it may be learned that the circuit does not need to consider an influence caused by the offset voltage VOS of the comparator 401. The sampling voltage $V_{VIN1}$ of the voltage sampling end VIN is related with only the actual value of R3 and a value of $I_T$. Even though the sampling voltage is very small, the sampling voltage may also be precisely detected and determined. If the foregoing circuit is applied to a battery pack, charging and discharging states of the battery pack may be correctly identified.

In conclusion, according to the voltage detection and determination circuit in this embodiment of the present invention, the detection processing module outputs the first detection voltage after performing level shift processing on the voltage sampled by the voltage sampling end, the detection similarity processing module imitates the detection processing module, to generate the reference voltage, then the current source module provides the bias current to the detection processing module and the detection similarity processing module, and finally the comparison processing module performs comparison processing on the first detection voltage and the reference voltage, to detect and determine the voltage sampled by the voltage sampling end. The circuit does not need a reference voltage, and has a simple circuit structure. Moreover, there is no need to consider an influence caused by an offset voltage of a comparator. A voltage sampled by a sampling end may be accurately detected and determined, so that charging and discharging states of a battery pack may be correctly identified.

In addition, an embodiment of the present invention further provides a power battery system, including the foregoing voltage detection and determination circuit.

According to the power battery system in this embodiment of the present invention, by using the foregoing voltage detection and determination circuit, the detection similarity processing module is used to imitate the detection processing module, to generate a reference voltage. A reference voltage is not needed, and a circuit structure is simple. Moreover, there is no need to consider an influence caused by an offset voltage of a comparator. A voltage sampled by a sampling end may be accurately detected and determined, so that charging and discharging states of a battery pack may be correctly identified.

In the descriptions of the present invention, it should be understood that an orientation or position relationship indicated by the term, such as "central", "longitudinal", "transverse", "length", "width", "thickness", "above", "below", "front", "rear", "left", "right", "vertical", "horizontal", "top", "bottom", "internal", "external", "clockwise", "anticlockwise", "axial", "radial", or "circumferential", is an orientation or position relationship shown based on the accompanying drawings. The term is used only for ease of description of the present invention and simplification of description, rather than indicating or implying that an indicated apparatus or element needs to have a particular orientation and to be constructed and operated at the particular orientation. Therefore, the terms cannot be constructed as limitation to the present invention.

In addition, the terms "first" and "second" are only used for the purpose of description, but cannot be constructed as indication or implication of relative importance or implied indication of quantities of indicated technical features. Therefore, features limited by the "first" and the "second" may expressly or impliedly indicate that at least one of the features is included. In description of the present invention, the meaning of "multiple" means at least two, for example, two or three, unless it is expressly and specifically defined.

In the present invention, unless otherwise clearly specified and limited, the terms such as "installation", "link", "connection", and "fixation" should be understood broadly. For example, the "connection" may be fixed connection, may be removable connection, or may be integrated into one; may be mechanical connection, or may be electric connection; or may be direct connection, may be indirect connection by using an intermediate medium, may be communication inside two elements, or may be a relationship of interaction between two elements, unless otherwise clearly limited. A person of ordinary skill in the art may understand specific means of the foregoing terms in the present invention according to a specific case.

In the present invention, unless otherwise clearly specified and limited, a first feature "above" or "below" a second feature may be that the first feature is in direct contact with the second feature, or the first feature is in indirect contact with the second feature by using an intermediate medium. Moreover, the first feature "above", "over" or "on" the second feature may be that the first feature may be above the second feature, or merely indicates that a level of the first feature is higher than that of the second feature. The first feature "below", "beneath" or "under" the second feature may be that the first feature may be below the second feature, or merely indicates that a level of the first feature is less than that of the second feature.

In description of this specification, description of the reference term such as "an embodiment", "some embodiments", "an example", "a specific example", or "some examples" means that a specific feature, a structure, a material or a characteristic that is described with reference to the embodiment or example is included in at least one embodiment or example of the present invention. In this specification, schematic description of the foregoing terms is unnecessarily for a same embodiment or example. Moreover, the described specific feature, structure, material or characteristic may be combined in any proper manner in any one or multiple embodiments or examples. In addition, a person skilled in the art may integrate and combine different embodiments or examples described in this specification or features thereof as long as no conflict occurs.

Although the above shows and describes the embodiments of the present invention, it may be understood that the foregoing embodiments are exemplary, cannot be constructed as limitation to the present invention. A person of ordinary skill in the art may make variations, modification, replacement or deformation to the foregoing embodiments within the scope of the present invention.

**Claims**

1. A voltage detection and determination circuit, comprising:

   a detection processing module, wherein the detection processing module is connected to a voltage sampling end, and the detection processing module is configured to output a first detection voltage based on a voltage sampled by the voltage sampling end;
   a detection similarity processing module, wherein the detection similarity processing module is configured to imitate the detection processing module, to generate a reference voltage corresponding to the first detection voltage;
   a current source module, wherein the current source module is connected to the detection processing module and the detection similarity processing module, and the current source module provides a bias current to the detection processing module and the detection similarity processing module; and
   a comparison processing module, wherein the comparison processing module is connected to the detection processing module and the detection similarity processing module, and the comparison processing module performs comparison processing on the first detection voltage and the reference voltage, to output a voltage detection signal.

2. The voltage detection and determination circuit according to claim 1, wherein the detection processing module is further configured to perform level shift processing on the voltage sampled by the voltage sampling end, to output the first detection voltage.

3. The voltage detection and determination circuit according to claim 1, wherein the detection similarity processing module comprises:

a resistance trimming unit, wherein the resistance trimming unit is connected between the current source module and the comparison processing module, and the resistance trimming unit is configured to perform resistance trimming based on resistance and current parameters of the detection similarity processing module and a voltage of first sampling of the voltage sampling end.

4. The voltage detection and determination circuit according to claim 1, wherein the current source module comprises an internal constant current source and a current mirror unit.

5. The voltage detection and determination circuit according to claim 4, wherein the current mirror unit comprises:

a first PMOS transistor, wherein both a source and a gate of the first PMOS transistor are connected to a positive terminal of the internal constant current source, and a negative terminal of the internal constant current source is grounded;
a second PMOS transistor, wherein both a source and a gate of the second PMOS transistor are connected to a drain of the first PMOS transistor, and a drain of the second PMOS transistor is connected to an internal power supply;
a third PMOS transistor, wherein a drain of the third PMOS transistor is connected to the detection processing module, and a gate of the third PMOS transistor is connected to the gate of the first PMOS transistor;
a fourth PMOS transistor, wherein a drain of the fourth PMOS transistor is connected to a source of the third PMOS transistor, a gate of the fourth PMOS transistor is connected to the gate of the second PMOS transistor, and a source of the fourth PMOS transistor is connected to the internal power supply;
a fifth PMOS transistor, wherein a drain of the fifth PMOS transistor is connected to the detection similarity processing module, and a gate of the fifth PMOS transistor is connected to the gate of the first PMOS transistor; and
a sixth PMOS transistor, wherein a drain of the sixth PMOS transistor is connected to a source of the fifth PMOS transistor, a gate of the sixth PMOS transistor is connected to the gate of the second PMOS transistor, and a source of the sixth PMOS transistor is connected to the internal power supply.

6. The voltage detection and determination circuit according to claim 1, wherein the detection processing module comprises:

a first resistor, wherein one end of the first resistor is connected to the current source module and the comparison processing module;
a seventh PMOS transistor, wherein a source of the seventh PMOS transistor is connected to the other end of the first resistor, and a gate of the seventh PMOS transistor is connected to the voltage sampling end; and
a second resistor, wherein one end of the second resistor is connected to a drain of the seventh PMOS transistor, and the other end of the second resistor is grounded.

7. The voltage detection and determination circuit according to claim 3, wherein the detection similarity processing module comprises:

an eighth PMOS transistor, wherein a source of the eighth PMOS transistor is connected to the resistance trimming unit, and a gate of the eighth PMOS transistor is grounded; and
a third resistor, wherein one end of the third resistor is connected to a drain of the eighth PMOS transistor, and the other end of the third resistor is grounded.

8. The voltage detection and determination circuit according to claim 7, wherein the resistance trimming unit comprises:

a trimming resistor, wherein one end of the trimming resistor is connected to the current source module and the comparison processing module, and the other end of the trimming resistor is connected to the source of the eighth PMOS transistor; and
a fuse, wherein the fuse and the trimming resistor are connected in parallel.

9. The voltage detection and determination circuit according to any one of claims 1 to 8, wherein the comparison processing module comprises:

a comparator, wherein a positive input terminal of the comparator is connected to the detection similarity processing module, and a negative input terminal of the comparator is connected to the detection processing module; and

a phase inverter, wherein an input terminal of the phase inverter is connected to an output terminal of the comparator, and an output terminal of the phase inverter is configured to output the voltage detection signal.

10. A power battery system, comprising the voltage detection and determination circuit according to any one of claims 1 to 9.

P +

Rload

IC

VIN        DO           CO

Rsense

Current direction
during discharging

FIG. 1

P +

Charger

IC

VIN        DO           CO

Rsense

Current direction
during charging

FIG. 2

FIG. 3

FIG. 4

FIG. 5

FIG. 6

FIG. 7

# INTERNATIONAL SEARCH REPORT

| | International application No. |
|---|---|
| | **PCT/CN2017/086005** |

## A. CLASSIFICATION OF SUBJECT MATTER

G01R 31/36(2006.01) i; G01R 19/165 (2006.01) i

According to International Patent Classification (IPC) or to both national classification and IPC

## B. FIELDS SEARCHED

Minimum documentation searched (classification system followed by classification symbols)

G01R; H01M

Documentation searched other than minimum documentation to the extent that such documents are included in the fields searched

Electronic data base consulted during the international search (name of data base and, where practicable, search terms used)

CNABS; CNKI; CNTXT; DWPI; SIPOABS: charge, discharge, recognition, offset, detection, sampling, collect, current source, constant current source, current mirror, compare, battery, accumulator, cell, reference, voltage, current, source, supply, mirror, comparator

## C. DOCUMENTS CONSIDERED TO BE RELEVANT

| Category* | Citation of document, with indication, where appropriate, of the relevant passages | Relevant to claim No. |
|---|---|---|
| A | CN 101144836 A (FEATURE INTEGRATION TECHNOLOGY INC.), 19 March 2008 (19.03.2008), claims 1 and 4, and description, page 3, line 20 to page 4, line 7, and figure 2 | 1-10 |
| A | CN 101133507 A (FUELCELL ENERGY, INC.), 27 February 2008 (27.02.2008), the whole document | 1-10 |
| A | US 9362874 B2 (FAIRCHILD SEMICONDUCTOR), 07 June 2016 (07.06.2016), the whole document | 1-10 |
| A | CN 101140302 A (PULIER SCIENCE AND TECHNOLOGY CO., LTD.), 12 March 2008 (12.03.2008), the whole document | 1-10 |
| A | CN 105467193 A (ZGMICRO CORPORATION), 06 April 2016 (06.04.2016), the whole document | 1-10 |
| A | JP 2006112906 A (SANYO ELECTRIC CO.), 27 April 2006 (27.04.2006), the whole document | 1-10 |

☐ Further documents are listed in the continuation of Box C.   ☒ See patent family annex.

| *   Special categories of cited documents: | "T"   later document published after the international filing date or priority date and not in conflict with the application but cited to understand the principle or theory underlying the invention |
|---|---|
| "A"   document defining the general state of the art which is not considered to be of particular relevance | |
| "E"   earlier application or patent but published on or after the international filing date | "X"   document of particular relevance; the claimed invention cannot be considered novel or cannot be considered to involve an inventive step when the document is taken alone |
| "L"   document which may throw doubts on priority claim(s) or which is cited to establish the publication date of another citation or other special reason (as specified) | "Y"   document of particular relevance; the claimed invention cannot be considered to involve an inventive step when the document is combined with one or more other such documents, such combination being obvious to a person skilled in the art |
| "O"   document referring to an oral disclosure, use, exhibition or other means | |
| "P"   document published prior to the international filing date but later than the priority date claimed | "&" document member of the same patent family |

| Date of the actual completion of the international search | Date of mailing of the international search report |
|---|---|
| 23June 2017 (23.06.2017) | **26July 2017 (26.07.2017)** |

| Name and mailing address of the ISA/CN: State Intellectual Property Office of the P. R. China No. 6, Xitucheng Road, Jimenqiao Haidian District, Beijing 100088, China Facsimile No.: (86-10) 62019451 | Authorized officer **MIAO, Wen** Telephone No.:(86-10) **62085340** |
|---|---|

Form PCT/ISA/210 (second sheet) (July 2009)

EP 3 470 860 A1

## INTERNATIONAL SEARCH REPORT
### Information on patent family members

| International application No. |
| --- |
| PCT/CN2017/086005 |

| Patent Documents referred in the Report | Publication Date | Patent Family | Publication Date |
| --- | --- | --- | --- |
| CN 101144836 A | 19 March 2008 | None | |
| CN 101133507 A | 27 February 2008 | JP 5231813 B2 | 10 July 2013 |
| | | WO 2006083080 A1 | 10 August 2006 |
| | | US 2009305086 A1 | 10 December 2009 |
| | | EP 1849202 B1 | 18 June 2014 |
| | | JP 2008530729 A | 07 August 2008 |
| | | US 8289027 B2 | 16 October 2012 |
| | | EP 1849202 A4 | 31 July 2013 |
| | | CN 100565999 C | 02 December 2009 |
| | | KR 20060089842 A | 09 August 2006 |
| | | KR 100778287 B1 | 22 November 2007 |
| | | EP 1849202 A1 | 31 October 2007 |
| US 9362874 B2 | 07 June 2016 | KR 20150007246 A | 20 January 2015 |
| | | US 2015015333 A1 | 15 January 2015 |
| CN 101140302 A | 12 March 2008 | None | |
| CN 105467193 A | 06 April 2016 | None | |
| JP 2006112906 A | 27 April 2006 | TW 200619639 A | 16 June 2006 |
| | | US 2006082395 A1 | 20 April 2006 |
| | | KR 20060053236 A | 19 May 2006 |
| | | CN 1760681 A | 19 April 2006 |
| | | CN 100451664 C | 14 January 2009 |
| | | US 7224192 B2 | 29 May 2007 |
| | | KR 100703098 B1 | 06 April 2007 |
| | | TW I267643 B | 01 December 2006 |

Form PCT/ISA/210 (patent family annex) (July 2009)

14

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 201610402877